# EUROPÄISCHE PATENTSCHRIFT

(11) **EP 2 114 608 B1**
(45) Veröffentlichungstag und Bekanntmachung des Hinweises auf die Patenterteilung: **06.03.2013**
(21) Anmeldenummer: 08706796.3
(22) Anmeldetag: 24.01.2008
(51) Int. Cl.: B23K 1/00, B23K 1/005, B23K 3/06, H05K 3/34

(54) **VERFAHREN UND VORRICHTUNG ZUR KONTAKTIERUNG EINES LOTKUGELVERBANDS**
METHOD OF AND DEVICE FOR CONTACTING A SOLDER BALL FORMATION
PROCÉDÉ DE ET DISPOSITIF POUR LA MISE EN CONTACT D'UNE STRUCTURE DE BRASAGE SOUS FORME DE BALLA

(30) Priorität: 24.01.2007 DE 102007004543
(43) Veröffentlichungstag der Anmeldung: 11.11.2009
(73) Patentinhaber: Pac Tech - Packaging Technologies GmbH, 14641 Nauen (DE)
(72) Erfinder: AZDASHT, Ghassem, 13591 Berlin (DE)
(74) Vertreter: Tappe, Hartmut
(86) Internationale Anmeldenummer: PCT/DE2008/000128
(87) Internationale Veröffentlichungsnummer: WO 2008/089743

(56) Entgegenhaltungen:
- US-A- 4 963 714
- US-A- 5 741 410
- US-A- 6 059 176
- US-A1- 2006 065 641
- US-A1- 2006 065 642
- US-B1- 6 460 755
- US-B1- 6 769 599
- DATABASE WPI Week 200664 Derwent Publications Ltd., London, GB; AN 2006-616533 XP002484163 & JP 2006 221690 A (ALPS ELECTRIC CO LTD) 24. August 2006 (2006-08-24)

## Beschreibung

Die vorliegende Erfindung betrifft ein Verfahren zur Kontaktierung eines Lotkugelverbands gemäß dem Oberbegriff des Anspruchs 1. Des Weiteren betrifft die Erfindung eine Vorrichtung zur Kontaktung eines Lothugelverbands gemäß dem Oberbegriff des Anspruch 7 (siehe US 2006/065 641, z.B., für die beiden Ansprüche).

Zur Kontaktierung von miteinander elektrisch leitfähig zu kontaktierenden Bauelementen und insbesondere Gruppen von Bauelementen hat sich in der Praxis eine Lotkugelkontaktierung durchgesetzt, bei der Lotkugeln aus einem Lotkugelreservoir vereinzelt werden, nachfolgend an den Kontaktstellen der Kontaktpartner platziert und schließlich durch Beaufschlagung mit thermischer Energie zur Herstellung der gewünschten elektrisch leitfähigen Verbindung aufgeschmolzen werden. Insbesondere bei einem industriellen Einsatz des bekannten Verfahrens kommt es darauf an, die Vielzahl der vorgenannten Verfahrensschritte bei einer möglichst großen Anzahl von zwischen Kontaktpartnern herzustellenden Lotverbindungen in möglichst kurzer Zeit durchführen zu können. Daher ist man in der Vergangenheit bereits auch dazu übergegangen, die Entnahme und Vereinzelung von Lotkugeln aus einem Lotkugelreservoir für eine zur späteren Kontaktierung benötigte Anordnung einer Mehrzahl von Lotkugeln in einem gemeinsamen Verfahrensschritt durchzuführen. Hierzu sind Entnahmeeinrichtungen entwickelt worden, die die Entnahme der gewünschten Anzahl von Lotkugeln bei gleichzeitig vereinzelnder Ausrichtung der Lotkugeln ermöglichen.

Ebenfalls ist es bereits bekannt, eine derartige Entnahmevorrichtung zur Platzierung der Lotkugeln an korrespondierend mit der Anordnung der Lotkugeln in der Entnahmevorrichtung angeordneten Kontaktstellen einer Kontaktanordnung zu verwenden. Zur nachfolgenden Kontaktierung der an den Kontaktstellen platzierten Lotkugeln ist es bislang notwendig, die Lotkugeln durch eine von der Entnahme- bzw. Platzierungsvorrichtung unabhängige Kontaktiereinrichtung mit thermischer Energie zu beaufschlagen. Hierdurch ist es notwendig, vor dem eigentlichen Verbindungsvorgang, also vor dem Energieeintrag in die Kontaktstellen durch die Kontaktiereinrichtung, die erforderliche Relativausrichtung zwischen der Verbindungseinrichtung und den Lotkugeln bzw. zwischen der Verbindungseinrichtung und der die Lotkugeln haltenden Entnahme-/Platzierungseinrichtung herbeizuführen. Hiermit ist ein entsprechender Justier- und Handhabungsaufwand verbunden, der darüber hinaus zu seiner Durchführung auch eine entsprechende Zeit benötigt.

Der vorliegenden Erfindung liegt daher die Aufgabe zu Grunde, ein Verfahren bzw. eine Vorrichtung zur Kontaktierung eines Lotkugelverbands vorzuschlagen, das bzw. die die Kontaktierung eines Lotkugelverbands vereinfacht und beschleunigt.

Diese Aufgabe wird durch ein Verfahren mit den Merkmalen des Anspruchs 1 bzw. eine Vorrichtung mit den Merkmalen des Anspruchs 7 gelöst.

Bei dem erfindungsgemäßen Verfahren erfolgt sowohl die vereinzelnde Aufnahme einer Mehrzahl von in einem Verband angeordneten Lotkugeln aus einem Lotkugelreservoir als auch die Platzierung der im Verband angeordneten Lotkugeln an den Kontaktstellen als auch die nachfolgende Kontaktierung der an den Kontaktstellen angeordneten Lotkugeln vermittels einer Beaufschlagung der Lotkugeln mit Laserenergie über die die Lotkugeln aus dem Lotkugelreservoir aufnehmenden Kontaktmundstücke.

Bei der Durchführung des erfindungsgemäßen Verfahrens entfällt somit die Notwendigkeit des Einsatzes unterschiedlicher Einrichtungen zur Durchführung der verschiedenen Verfahrensschritte. Stattdessen wird bei dem erfindungsgemäßen Verfahren die vereinzelnde Aufnahme, die Platzierung der Lotkugeln an den Kontaktstellen und die Durchführung der eigentlichen Kontaktierung mittels ein und derselben Kontaktiervorrichtung durchgeführt.

Als besonders vorteilhaft erweist es sich, wenn die Kontaktmundstücke zur Aufnahme der Lotkugeln aus dem Lotkugelreservoir mit einem Vakuum beaufschlagt werden.

Besonders vorteilhaft ist es auch, wenn während der Aufnahme der Lotkugeln aus dem Lotkugelreservoir eine Beaufschlagung des Lotkugelreservoirs mit Ultraschall erfolgt, um zum einen eine statistisch regelmäßige Verteilungsdichte der Lotkugeln im Reservoir zu erzielen und zum anderen durch die Ultraschallvibrationen ein Hochspringen der Lotkugeln zu bewirken, so dass zur vereinfachten Aufnahme der Lotkugeln im Lotkugelreservoir Abstände zwischen den Lotkugeln erzeugt werden.

Wenn die Kontaktmundstücke nach Platzierung der Lotkugeln an den Kontaktstellen gegenüber den aus den Lotkugeln und den Kontaktstellen gebildeten Kontaktanordnungen, gemäß den Erfindung, verschwenkt werden, ist es möglich, die Richtung der Energiebeaufschlagung der Lotkugeln durch die Kontaktiereinrichtung abweichend von der Zustellrichtung beim Platziervorgang zu wählen, um einen optimierten Energieeintrag in die Kontaktstellen zu ermöglichen.

Als besonders vorteilhaft erweist es sich dabei, wenn die Kontaktmundstücke unter Aufrechterhaltung des Kontaktdrucks gegenüber den Kontaktanordnungen verschwenkt werden, so dass auch nach Durchführung des Schwenkvorgangs eine Kontaktierung der Lotkugeln möglich ist, ohne zwischenzeitige Ausbildung eines Kontaktspaltes.

Eine weitere vorteilhafte Variante des Verfahrens besteht darin, nach der Aufnahme der Lotkugeln aus dem Lotkugelreservoir und vor dem Platzieren der Lotkugeln an den Kontaktstellen eine Beschichtung der Lotkugeln mit einem Flussmittel vorzunehmen, um die Qualität der durch die Kontaktierung hergestellten Lotverbindungen zwischen den Kontaktpartnern gegebenenfalls noch zu erhöhen.

Wenn die Beschichtung durch ein zumindest teilweises Eintauchen der Lotkugeln in ein Flussmittelreservoir erfolgt, die Lotkugeln des Lotkugelverbands also quasi in einem Dipverfahren mit einem Flussmittelauftrag versehen werden, kann die Beschichtung ohne großen zusätzlichen zeitlichen oder apparativen Aufwand während der Überführung der Kontaktmundstücke aus dem Lotkugelreservoir zu den Kontaktstellen erfolgen.

Zur Einrichtung einer besonderen Qualitätssicherung ist es auch möglich, die mit den Kontaktmundstücken zusammenwirkende Lasereinrichtung vor Durchführung des thermischen Verbindungsvorgangs durch Aufschmelzen der Lotkugeln unmittelbar nach der Platzierung zur Durchführung einer Positionierungsprüfung bzw. einer Prüfung auf Fehlstellen zu verwenden.

Die erfindungsgemäße Vorrichtung weist eine Mehrzahl von in einem Verband angeordneten Kontaktmundstücken und ein Lotkugelreservoir zur Aufnahme einer Vielzahl von Lotkugeln auf, wobei die Kontaktmundstücke sowohl zur Aufnahme der Lotkugeln aus dem Lotkugelreservoir als auch zur Platzierung der Lotkugeln an den Kontaktstellen als auch zur Beaufschlagung der Lotkugeln mit Laserenergie zur thermischen Verbindung der Lotkugeln mit den Kontaktstellen dienen.

Bei einer bevorzugten Ausführungsform der Vorrichtung sind in den Kontaktmundstücken Vakuumkanäle zur Beaufschlagung der Lotkugeln mit Vakuum ausgebildet.

Weiterhin ist es vorteilhaft, wenn an dem Lotkugelreservoir eine Einrichtung zur Beaufschlagung des Lotkugelreservoirs mit Ultraschallschwingungen angeordnet ist.

Wenn die Kontaktmundstücke schwenkbar an der Kontaktiervorrichtung angeordnet sind, lässt sich in besonderem Maße eine Anpassung der Ausrichtung der Kontaktmundstücke an die Gegebenheiten bzw. Relativanordnung der Kontaktstellen herstellen.

Die gemeinsame Handhabung der Kontaktmundstücke in einem Verband wird vereinfacht, wenn die Kontaktmundstücke an einer Trägervorrichtung der Kontaktiervorrichtung angeordnet sind.

Von besonderem Vorteil ist es, wenn die Anordnung der Kontaktmundstücke eine Reihen- oder Matrixanordnung aufweist, so dass eine den meisten Relativanordnungen von Kontaktstellen entsprechende Standardanordnung der Kontaktmundstücke gegeben bzw. einstellbar ist. Als besonders vorteilhaft erweist es sich, wenn die Kontaktmundstücke in ihrer Relativanordnung an der Trägereinrichtung veränderbar sind, um beispielsweise auch einzeln oder gruppenweise von einer Reihen- oder Matrixanordnung abweichende Anordnungen von Kontaktstellen mit den an der Trägervorrichtung angeordneten Kontaktiereinrichtungen beaufschlagen zu können.

Als besonders vorteilhaft hinsichtlich einer platzsparenden und funktionsintegrierten Ausführung der Kontaktmundstücke erweist es sich, wenn die Kontaktmundstücke zur Beaufschlagung der Lotkugeln mit Laserenergie eine im Vakuumkanal geführte Lichtleiteinrichtung aufweisen.

Wenn die Lichtleiteinrichtung als Lichtleitfaser ausgebildet ist, kann die Lichtleitfaser gleichzeitig zur Einleitung der Laserenergie in die Kontaktmundstücke und nicht nur zur Führung der Laserenergie innerhalb der Kontaktmundstücke genutzt werden. Darüber hinaus ermöglicht die Ausbildung der Lichtleiteinrichtung als Lichtleitfaser es auch, die Lichtleiteinrichtung als Stößeleinrichtung zu verwenden, um etwaige an der Austriebsöffnung des Kontaktmundstücks ausgebildete Verunreinigungen entfernen zu können.

Eine besonders einfache und effektive Möglichkeit der Synchronisation der Lichtleiteinrichtungen bietet sich, wenn die Lichtleitfasern mehrerer Kontaktmundstücke an eine Laserquelle angeschlossen sind.

Insbesondere bei unterschiedlich ausgebildeten Kontaktstellen, die in einem gemeinsamen Bestückungs-/ Belotungsvorgang bearbeitet werden sollen, erweist es sich als vorteilhaft, wenn die Lichtleitfasern der Kontaktmundstücke zu mehreren Lichtleitfasergruppen zusammengefasst sind, die zumindest teilweise an unterschiedliche Laserquellen angeschlossen sind. Dabei können die Laserquellen Laserlicht unterschiedlicher Leistung emittieren.

Nachfolgend wird eine bevorzugte Ausführungsform der Vorrichtung zur Erläuterung des damit durchführbaren Verfahrens anhand der Zeichnungen näher erörtert.

Es zeigen:
- **Fig. 1:**: eine Lotkugelkontaktiervorrichtung bei der Aufnahme von Lotkugeln aus einem Lotkugelreservoir;
- **Fig. 2:**: die Lotkugelkontaktiervorrichtung bei der Beschichtung von Lotkugeln mit Flussmittel;
- **Fig. 3:**: die Lotkugelkontaktiervorrichtung mit an Kontaktmundstücken angeordneten und mit Flussmittel beschichteten Lotkugeln;
- **Fig. 4:**: die Lotkugelkontaktiervorrichtung bei der Beaufschlagung der Lotkugeln mit Laserenergie;
- **Fig. 5:**: ein Kontaktmundstück der Lotkugelkontaktiervorrichtung bei der Platzierung einer Lotkugel gegen eine Kontaktpaarung;
- **Fig. 6:**: das in **Fig. 5** dargestellte Kontaktmundstück in einer verschwenkten Kontaktierstellung;
- **Fig. 7:**: eine an einer Kontaktflächenpaarung platzierte Lotkugel;
- **Fig. 8:**: die in **Fig. 7** dargestellte Kontaktflächenpaarung bei Beaufschlagung der Lotkugel mit Laserenergie.

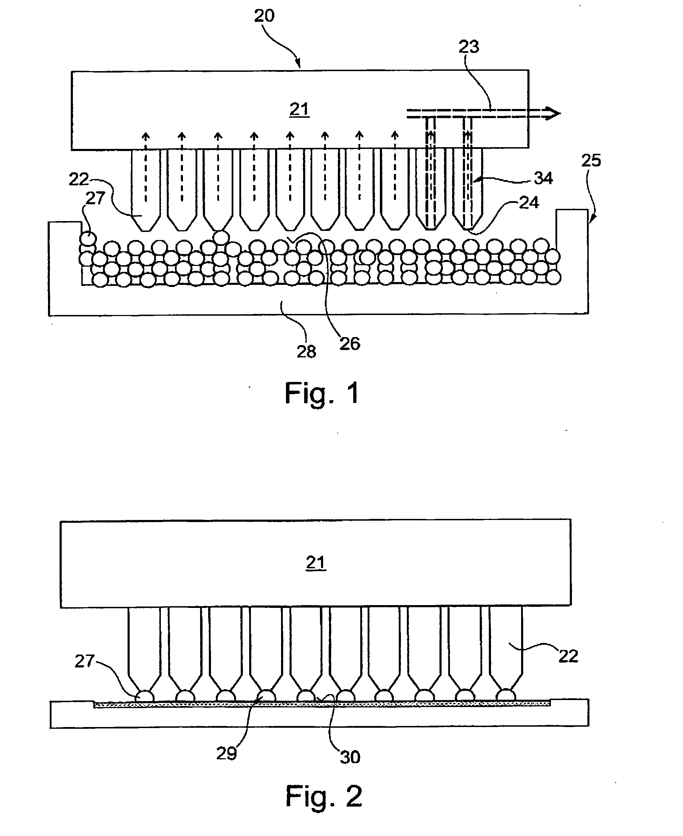

**Fig. 1** zeigt eine Lotkugelkontaktiervorrichtung 20 mit einer Mehrzahl von hier als Kanülen ausgebildeten, an einer Trägereinrichtung 21 angeordneten Kontaktmundstücken 22. Die einzelnen Kontaktmundstücke 22 sind jeweils an eine Vakuumeinrichtung 23 angeschlossen, so dass bei entsprechender Beaufschlagung an Kontaktöffnungen 24 der Kontaktmundstücke 22 ein Vakuum anliegt.

Die Lotkugelkontaktvorrichtung 20 befindet sich über einem in einem Aufnahmebehältnis 25 angeordneten Lotkugelreservoir 26 mit einer Vielzahl von Lotkugeln 27. Das Aufnahmebehältnis 25 ist vermittels einer hier nicht näher dargestellten Ultraschalleinrichtung mit Ultraschall beaufschlagbar, um das Aufnahmebehältnis 25 oder zumindest Teilbereiche des Aufnahmebehältnisses 25, wie beispielsweise einen Behältnisboden 28, mit einer Schwingungsamplitude zu beaufschlagen. Die Schwingungsamplitude wird auf die Lotkugeln 27 des Lotkugelreservoirs 26 übertragen und versetzt diese in eine Auf- und Abbewegung relativ zum Aufnahmebehältnis 25. Durch diese Auf- und Abbewegung werden die Abstände zwischen den Lotkugeln 27 zum einen vergrößert, zum anderen erfolgt eine statistisch regelmäßige Verteilung der Lotkugeln 27 im Aufnahmebehältnis 25, ohne dass sich lokale Häufungen bilden würden.

Um bei Beaufschlagung der Kontaktmundstücke 22 mit Vakuum das Ansaugen der Lotkugeln 27 gegen die Kontaktöffnung 24 zu erleichtern, kann insbesondere der Behältnisboden 28 mit Luftdurchlässen versehen sein.

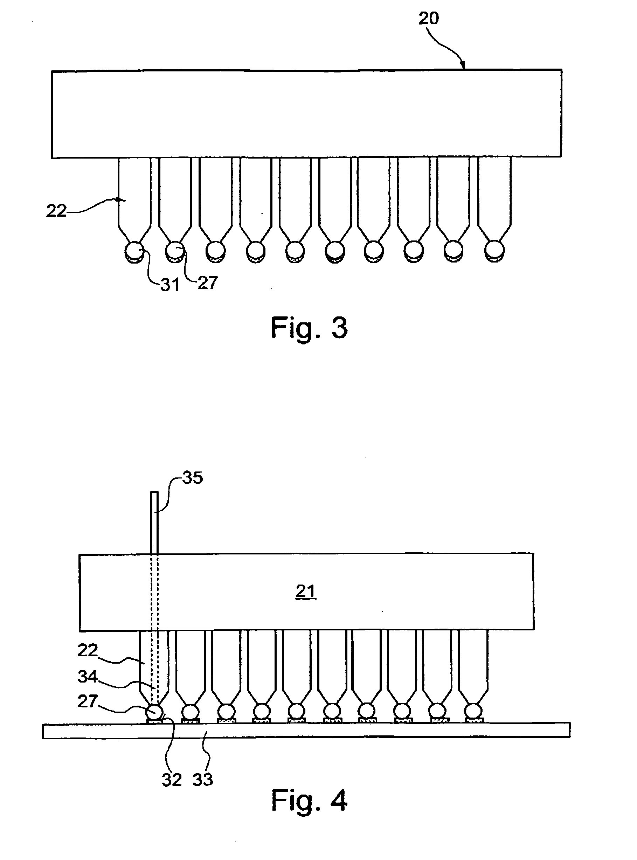

Wie **Fig. 2** zeigt, ist es möglich, die an der Lotkugelkontaktiervorrichtung 20 vereinzelt in einem Lotkugelverband 29 angeordneten Lotkugeln 27 durch zumindest teilweises Eintauchen in ein Flussmittelreservoir 30 mit einem Flussmittelauftrag 31, wie in **Fig. 3** dargestellt, zu versehen.

**Fig. 4** zeigt nun die Platzierung der im Lotkugelverband 29 angeordneten Lotkugeln 27 auf Kontaktflächen 32 eines Substrates 33, das beispielsweise als elektronisches Bauelement ausgebildet sein kann.

In **Fig. 4** ist auch beispielhaft am äußeren linken Kontaktmundstück 22 ein Beaufschlagungskanal 34 des Kontaktmundstücks 22 dargestellt, der zum einen, wie bereits vorstehend ausgeführt, zur Verbindung mit der Vakuumeinrichtung 23 dient und zum anderen einen Endabschnitt der hier als Lichtleitfaser 35 ausgebildeten Lichtleiteinrichtung aufnimmt. Die Lichtleitfaser 35 ist nach oben aus dem Kontaktmundstück bzw. der Trägereinrichtung 21 herausgeführt und mit ihrem Anschlussende an eine hier nicht näher dargestellte Laserquelle bzw. eine mit einer Laserquelle verbundene Lichteinkopplungseinrichtung angeschlossen. Diese Lichteinkopplungseinrichtung kann als Verteilereinrichtung ausgebildet sein, die von einer Laserquelle emittierte Laserenergie an die Mehrzahl von Lichtleitfasern der Mehrzahl von Kontaktmundstücken 22 verteilt.

Die in **Fig. 1** dargestellte Lotkugelkontaktiervorrichtung 20 weist eine Reihenanordnung von Kontaktmundstücken 22 auf. Darüber hinaus kann die Lotkugelkontaktiervorrichtung 20 aber auch so ausgebildet sein, dass sie eine Matrixanordnung von Kontaktmundstücken 22 aufweist, bzw. eine Anordnung von Kontaktmundstücken 22, die eine der jeweiligen Anordnung der zu kontaktierenden Kontaktflächen der Kontaktsubstrate entsprechende ein- oder zweidimensionale Verteilungsanordnung von Kontaktmundstücken aufweist.

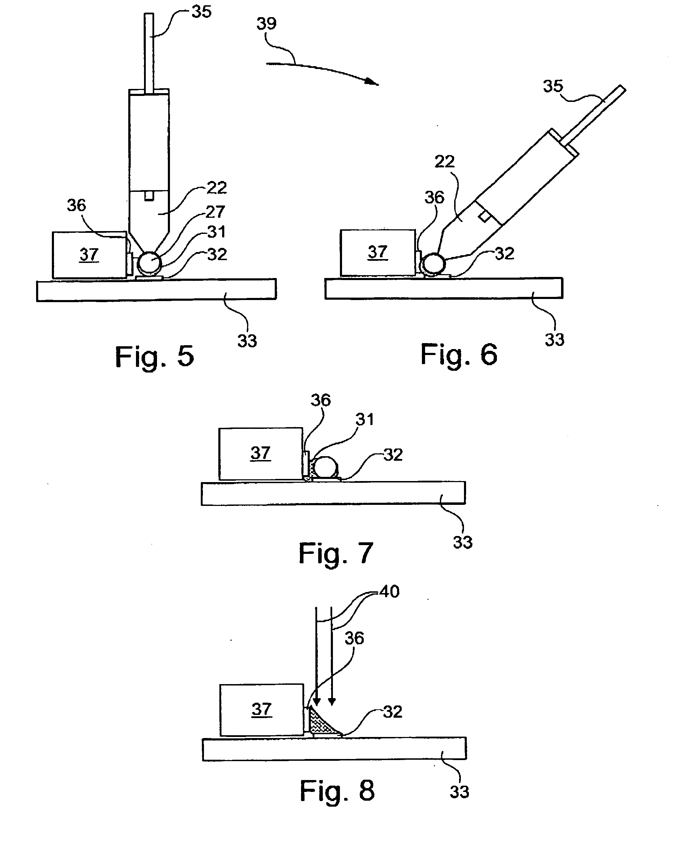

Die **Fig. 5** und **6** zeigen einen Platzierungsvorgang mit nachfolgender Kontaktierung, wobei die in **Fig. 4** dargestellte Lotkugelkontaktvorrichtung 20 mit einer Reihenanordnung von Kontaktmundstücken 22 zum Einsatz kommt. Bei dem dargestellten Ausführungsbeispiel sind demgemäß senkrecht zur Zeichenebene zehn Kontaktmundstücke angeordnet, die einen Verband von insgesamt zehn Lotkugeln 27 tragen und auf einer entsprechenden Anordnung von zehn Kontaktflächen 32 des Kontaktsubstrats 33 platzieren. Die Kontaktflächen 32 bilden jeweils zusammen mit einer Kontaktfläche 36 eines mit dem Substrat 33 zu kontaktierenden elektronischen Bauelements 37 an Kontaktstellen 41 Kontaktpaarungen 38 mit den räumlich zueinander angeordneten Kontaktflächen 32 und 36.

**Fig. 5** zeigt, dass in einem ersten Schritt die Lotkugeln 27 vermittels der Lotkugelkontaktiervorrichtung 20 gegen die hier in einer Horizontalebene angeordneten Kontaktflächen 32 des Substrats 33 zur Anlage gebracht werden. Anschließend erfolgt, wie in **Fig. 6** dargestellt, ein Verschwenken, gemäß den Erfindung, der Lotkugelkontaktvorrichtung 20 bzw. der Trägervorrichtung 21 um eine Schwenkachse 39, derart, dass am Ende des Schwenkvorgangs die Lotkugeln 27 des Lotkugelverbands sowohl an den Kontaktflächen 32 des Substrats 33 als auch den in einer Vertikalebene angeordneten Kontaktflächen 36 des Bauelements 37 anliegen. In dieser in **Fig. 6** dargestellten Stellung der Lotkugelkontaktiervorrichtung 20 bzw. des Verbands der Kontaktmundstücke 22 erfolgt dann die Beaufschlagung der Lotkugeln 27 mit Laserenergie über die Lichtleitfaser 35.

Alternativ und nicht im Gegenstand den Erfindung ist es möglich, wie in den **Fig. 7** und **8** dargestellt, nach einer Platzierung der Lotkugeln 27 mit Kontakt zu den Kontaktflächen 32 und 36 der Kontaktflächenpaarung 38 die Lotkugelkontaktiervorrichtung 20 von der Kontaktstelle 41 zu entfernen, um eine Beaufschlagung der Lotkugeln 27, wie in **Fig. 8** dargestellt, mit Laserenergie 40 durchzuführen, ohne dass ein Körperkontakt zwischen der Lotkugelkontaktiervorrichtung 20 und den Lotkugeln 27 besteht. Wie **Fig. 7** zeigt, wird die durch die Lotkugelkontaktiervorrichtung 20 hergestellte Anlage der Lotkugeln 27 gegen die Kontaktflächen 32 und 36 der Kontaktpaare 38 durch die adhäsive Wirkung des Flussmittelauftrags 31 oder ein anderes Adhäsionsmittel erreicht.

## Patentansprüche

1. Verfahren zur Kontaktierung eines Lotkugelverbands (29), bei dem vermittels einer Mehrzahl von in einem Verband angeordneten Kontaktmundstücken (22) ein entsprechend der Relativanordnung der Kontaktmundstücke zusammengesetzter Lotkugelverband aufgenommen wird, der Lotkugelverband vermittels der Kontaktmundstücke zur nachfolgenden Kontaktierung an Kontaktstellen (41) platziert wird und nachfolgend vermittels der Kontaktmundstücke eine Beaufschlagung der Lotkugeln mit Laserenergie (40) zur thermischen Verbindung mit den Kontaktstellen erfolgt,
**dadurch gekennzeichnet, dass** ein Lotkugel Reservoir (26) mit einen Vielzahl von regellos verhalten Lotkugeln (27) verwendet wird, und
dass die Kontaktmundstücke (22) nach Platzierung der Lotkugeln (27) an den Kontaktstellen (41) gegenüber den aus den Lotkugeln und den Kontaktstellen (41) gebildeten Kontaktanordnungen verschwenkt werden.

2. Verfahren nach Anspruch 1,
**dadurch gekennzeichnet,**
**dass** die Kontaktmundstücke (22) zur Aufnahme der Lotkugeln (27) aus dem Lotkugelreservoir (26) mit einem Vakuum beaufschlagt werden.

3. Verfahren nach Anspruch 1 oder 2,
**dadurch gekennzeichnet,**
**dass** während der Aufnahme der Lotkugeln (27) aus dem Lotkugelreservoir (26) eine Beaufschlagung des Lotkugelreservoirs mit Ultraschall erfolgt.

4. Verfahren nach einem der vorgehenden Ansprüche,
**dadurch gekennzeichnet,**
**dass** die Kontaktmundstücke (22) unter Aufrechterhaltung des Kontaktdrucks gegenüber den Kontaktanordnungen verschwenkt werden.

5. Verfahren nach einem der vorangehenden Ansprüche,
**dadurch gekennzeichnet,**
**dass** nach Aufnahme der Lotkugeln (27) aus dem Lotkugelreservoir (26) und vor dem Platzieren der Lotkugeln an den Kontaktstellen (41) eine Beschichtung (31) der Lotkugeln mit einem Flussmittel erfolgt.

6. Verfahren nach Anspruch 5,
**dadurch gekennzeichnet,**
**dass** die Beschichtung (31) durch ein zumindest teilweises Eintauchen der Lotkugeln (27) in ein Flussmittelreservoir (30) erfolgt.

7. Vorrichtung zur Kontaktierung eines Lotkugelverbands (29) mit einer Mehrzahl von in einem Verband angeordneten Kontaktmundstücken (22), wobei die Kontaktmundstücke sowohl zur Aufnahme der Lotkugeln aus dem Lotkugelreservoir als auch zur Platzierung der Lotkugeln an Kontaktstellen (41) als auch zur Beaufschlagung der Lotkugeln mit Laserenergie (40) zur thermischen Verbindung mit den Kontaktstellen dienen,
**dadurch gekennzeichnet, dass** die Vorrichtung, einen Lotkugelreservoir (26) zur Aufnahme einer Vielzahl von Lotkugeln (27) aufweist, und
dass die Kontaktmundstücke (22) verschwenkbar an der Kontaktiervorrichtung (20) angeordnet sind.

8. Vorrichtung nach Anspruch 7,
**dadurch gekennzeichnet,**
**dass** in den Kontaktmundstücken Vakuumkanäle (34) zur Beaufschlagung der Lotkugeln (27) mit Vakuum ausgebildet sind.

9. Vorrichtung nach Anspruch 7 oder 8,
**dadurch gekennzeichnet,**
**dass** am Lotkugelreservoir (26) eine Einrichtung zur Beaufschlagung des Lotkugelreservoirs mit Ultraschallschwingungen angeordnet ist.

10. Vorrichtung nach einem der Ansprüche 7 bis 9,
**dadurch gekennzeichnet,**
**dass** die Kontaktmundstücke (22) an einer Trägereinrichtung (21) der Kontaktiervorrichtung (20) angeordnet sind.

11. Vorrichtung nach einem der Ansprüche 7 bis 10,
**dadurch gekennzeichnet,**
**dass** die Kontaktmundstücke (22) in einer Reihen- oder Matrixanordnung an der Kontaktiervorrichtung (20) angeordnet sind.

12. Vorrichtung nach einem der Ansprüche 7 bis 11,
**dadurch gekennzeichnet,**
**dass** die Kontaktmundstücke (22) in ihrer Relativanordnung an der Kontaktiervorrichtung (20) veränderbar sind.

13. Vorrichtung nach einem der Ansprüche 7 bis 12,
**dadurch gekennzeichnet,**
**dass** die Kontaktmundstücke (22) zur Beaufschlagung der Lotkugeln (27) mit Laserenergie (40) eine im Vakuumkanal (34) geführte Lichtleiteinrichtung aufweisen.

14. Vorrichtung nach Anspruch 13.
**dadurch gekennzeichnet,**
**dass** die Lichtleiteinrichtung als Lichtleitfaser (35) ausgebildet ist.

15. Vorrichtung nach Anspruch 14,
**dadurch gekennzeichnet,**
**dass** die Lichtleitfasern (35) mehrerer Kontaktmundstücke (22) an eine Laserquelle angeschlossen sind.

16. Vorrichtung nach Anspruch 14 oder 15,
**dadurch gekennzeichnet,**
**dass** die Lichtleitfasern (35) der Kontaktmundstücke (22) zu mehreren Lichtleitfasergruppen zusammengefasst sind, die zumindest teilweise an unterschiedliche Laserquellen angeschlossen sind.

## Claims

1. A method for contacting a solder ball formation (29), in which a plurality of contact mouthpieces (22) arranged in a formation is used to pick up a solder ball formation with a composition reflecting the relative arrangement of the contact mouthpieces, the solder ball formation is placed on contact points (41) by means of the contact mouthpieces for subsequent contacting, and subsequently the solder balls are impinged with laser energy (40) by means of the contact mouthpieces for thermal connection with the contact points,
**characterized in that**
a solder ball reservoir (26) comprising a multitude of randomly distributed solder balls (27) is used and, after the solder balls (27) have been placed on the contact points (41), the contact mouthpieces (22) are pivoted relative to the contact arrangements formed by the solder balls and the contact points (41).

2. The method according to claim 1,
**characterized in that**
the contact mouthpieces (22) for picking up the solder balls (27) from the solder ball reservoir (26) are exposed to a vacuum.

3. The method according to claim 1 or 2,
**characterized in that**
the solder ball reservoir is exposed to ultrasound while the solder balls (27) are picked up from the solder ball reservoir (26).

4. The method according to one of the preceding claims,
**characterized in that**,
the contact mouthpieces (22) are pivoted relative to the contact arrangements while maintaining the contact pressure.

5. The method according to one of the preceding claims,
**characterized in that**
the solder balls are coated (31) with a flow agent after the solder balls (27) have been picked up from the solder ball reservoir (26) and before the solder balls are placed on the contact points (41).

6. The method according to claim 5,
**characterized in that**
the coating (31) takes place by at least partially submerging the solder balls (27) in a flow agent reservoir (30).

7. A device for contacting a solder ball formation (29) with a plurality of contact mouthpieces (22) arranged in a formation, wherein the contact mouthpieces are used both for picking up the solder balls from the solder ball reservoir and for placing the solder balls on contact points (41), as well as for impinging the solder balls with laser energy (40) for thermal connection with the contact points,
**characterized in that**
the device comprises a solder ball reservoir (26) for accommodating a multitude of solder balls (27) and the contact mouthpieces (22) are pivotably mounted to the contacting device (20).

8. The device according to claim 7,
**characterized in that**
vacuum channels (34) are incorporated in the contact mouthpieces for exposing the solder balls (27) to a vacuum.

9. The device according to claim 7 or 8,
**characterized in that**
a device for exposing the solder ball reservoir with ultrasound oscillations is arranged on the solder ball reservoir (26).

10. The device according to one of claims 7 to 9,
**characterized in that**
the contact mouthpieces (22) are arranged on a carrier device (21) of the contacting device (20).

11. The device according to one of claims 7 to 10,
**characterized in that**
the contact mouthpieces (22) are arranged in a row or matrix arrangement on the contacting device (20).

12. The device according to one of claims 7 to 11,
**characterized in that**
the contact mouthpieces (22) can be varied in terms of their relative arrangement on the contacting device (20).

13. The device according to one of claims 7 to 12,
**characterized in that**
the contact mouthpieces (22) exhibit an optical waveguide routed in the vacuum channel (34) for impinging the solder balls (27) balls (27) with laser energy (40).

14. The device according to claim 13,
**characterized in that**
the optical waveguide device is designed as an optical fibre (35).

15. The device according to claim 14,
**characterized in that**
the optical fibres (35) of several contact mouthpieces (22) are connected to one laser source.

16. The device according to claim 14 or 15,
**characterized in that**
the optical fibres (35) of the contact mouthpieces (22) are combined into several optical fibre groups, which are at least partially connected to various laser sources.

## Revendications

1. Procédé pour la mise en contact d'une formation de billes de brasage (29), dans lequel, au moyen d'une pluralité d' embouts de contact (22) arrangés en formation, une formation de billes de brasage composée conformément à l'arrangement relatif des embouts de contact est prélevée, la formation de billes de brasage est mise en place au moyen des embouts de contact pour la mise en contact subséquente à des points de contact (41) et ultérieurement de l'énergie laser (40) est appliquée aux billes de brasage au moyen des embouts de contact pour la liaison thermique avec les points de contact,
**caractérisé en ce qu'**
un réservoir (26) de billes de brasage avec une pluralité de billes de brasage (27) dispersées au hasard est utilisé, et qu'après la mise en place des billes de brasage (27) aux points de contact (41) les embouts de contact (22) sont pivotés par rapport aux arrangements de contact formés par les billes de brasage et les points de contact (41).

2. Procédé selon la revendication 1,
**caractérisé en ce qu'**
un vide est appliqué aux embouts de contact (22) en vue de prélever les billes de brasage (27) sur le réservoir de billes de brasage (26).

3. Procédé selon la revendication 1 ou 2,
**caractérisé en ce que**
pendant le prélèvement des billes de brasage (27) sur le réservoir de billes de brasage (26) de l'ultra-son est appliqué au réservoir de billes de brasage.

4. Procédé selon l'une quelconque des revendications précédentes,
**caractérisé en ce que**
les embouts de contact (22) sont pivotés par rapport aux arrangements de contact tout en maintenant la pression de contact.

5. Procédé selon l'une quelconque des revendications précédentes,
**caractérisé en ce qu'**
après le prélèvement des billes de brasage (27) sur le réservoir de billes de brasage (26) et avant la mise en place des billes de brasage aux points de contact (41) les billes de brasage sont dotées d'un revêtement (31) de flux de brasage.

6. Procédé selon la revendication 5,
**caractérisé en ce que**
le revêtement (31) s'effectue par une immersion au moins partielle des billes de brasage (27) dans un réservoir de flux de brasage (30).

7. Dispositif pour la mise en contact d'une formation de billes de brasage (29) avec une pluralité d' embouts de contact (22) arrangés en formation, dans lequel les embouts de contact servent à prélever les billes de brasage (27) sur le réservoir de billes de brasage, à mettre en place les billes de brasages à des points de contact (41) et à appliquer de l'énergie laser (40) aux billes de brasage pour la liaison thermique avec les points de contact,
**caractérisé en ce que**
le dispositif comprend un réservoir de billes de brasage (26) pour recevoir une pluralité de billes de brasage (27) et les embouts de contact (22) sont disposés au dispositif pour la mise en contact (20) de manière à être pivotables.

8. Dispositif selon la revendication 7,
**caractérisé en ce que**
des canaux à vide (34) sont formés dans les embouts de contact pour appliquer un vide aux billes de brasage (27).

9. Dispositif selon la revendication 7 ou 8,
**caractérisé en ce qu'**
un dispositif pour appliquer des oscillations d'ultra-son au réservoir de billes de brasage (26) est arrangé au réservoir de billes de brasage.

10. Dispositif selon l'une quelconque des revendications 7 à 9,
**caractérisé en ce que**
les embouts de contact (22) sont arrangés à un dispositif porteur (21) du dispositif pour la mise en contact (20).

11. Dispositif selon l'une quelconque des revendications 7 à 10,
**caractérisé en ce que**
les embouts de contact (22) sont disposés dans un arrangement en ligne ou en matrice sur le dispositif pour la mise en contact (20).

12. Dispositif selon l'une quelconque des revendications 7 à 11,
**caractérisé en ce que**
les embouts de contact (22) sont changeables en ce qui concerne leur arrangement relatif sur le dispositif pour la mise en contact (20).

13. Dispositif selon l'une quelconque des revendications 7 à 12,
**caractérisé en ce que**
les embouts de contact (22) comportent un dispositif de guidage de lumière guidé dans le canal à vide (34) pour appliquer de l'énergie laser (40) aux billes de brasage (27).

14. Dispositif selon la revendication 13,
**caractérisé en ce que**
le dispositif de guidage de lumière est réalisé comme fibre optique (35).

15. Dispositif selon la revendication 14,
**caractérisé en ce que**
les fibres optiques (35) de plusieurs embouts de contact (22) sont connectées à une source laser.

16. Dispositif selon la revendication 14 ou 15,
**caractérisé en ce que**
les fibres optiques (35) des embouts de contact (22) sont groupées en plusieurs groupes de fibres optiques qui sont connectés au moins partiellement à des sources laser différentes.
